# EUROPÄISCHE PATENTANMELDUNG

(11) **EP 3 029 648 A1**
(43) Veröffentlichungstag der Anmeldung: **08.06.2016**
(21) Anmeldenummer: 14200082.7
(22) Anmeldetag: 23.12.2014
(51) Int. Cl.: G08B 17/107, G01N 21/53

(54) **Streulichtrauchmelder mit zwei zweifarbigen Leuchtdioden und einem gemeinsamen Photosensor oder mit einer zweifarbigen Leuchtdiode und mit zwei Photosensoren jeweils in einer Vorwärts- und Rückwärtsstreulichtanordnung**

(30) Priorität: 01.12.2014 EP 14195593
(71) Anmelder: Siemens Schweiz AG, 8047 Zürich (CH)
(72) Erfinder: Walker, Stefan, 6460 Altdorf (CH)
(74) Vertreter: Maier, Daniel Oliver

(57) **Zusammenfassung**

Die Erfindung betrifft einen Streulichtrauchmelder (100) mit einer nach dem Streulichtprinzip arbeitenden Detektionseinheit (10). Er weist eine erste und zweite Leuchtdiode (1V, 1R) zum Bestrahlen von zu detektierenden Partikeln sowie einen dafür spektral empfindlichen gemeinsamen Photosensor (2) auf, wobei die beiden Leuchtdioden jeweils eine Sendeachse (SA) und der Photosensor eine Empfangsachse (EA) aufweisen. Beide Leuchtdioden sowie der Photosensor sind derart zueinander angeordnet und ausgerichtet, dass alle Achsen in einer gemeinsamen Ebene (W) liegen. Die erste Leuchtdiode ist mit dem Photosensor unter einem Vorwärtsstreuwinkel (αV) und die zweite Leuchtdiode mit dem Photosensor unter einem Rückwärtsstreuwinkel (αR) angeordnet. Erfindungsgemäss weisen beide Leuchtdioden jeweils einen ersten und zweiten LED-Chip (3, 4) zum Aussenden eines jeweiligen ersten und zweiten Lichtbündels (BL, RO) mit Licht in einem ersten und in einem davon verschiedenen zweiten Wellenlängenbereich auf. Alternativ weist der Rauchmelder nur eine Leuchtdiode (1) sowie einen ersten und zweiten Photosensor (2V, 2R) auf. Der erste Photosensor ist mit der Leuchtdiode unter einem Vorwärtsstreuwinkel und der zweite Photosensor mit der Leuchtdiode unter einem Rückwärtsstreuwinkel angeordnet. Erfindungsgemäss weist die Leuchtdiode wieder einen ersten und zweiten LED-Chip für Licht im ersten und zweiten Wellenlängenbereich auf.

## Beschreibung

Die Erfindung betrifft einen Streulichtrauchmelder mit einer nach dem Streulichtprinzip arbeitenden Detektionseinheit. Die Detektionseinheit weist eine erste und zweite Leuchtdiode zum Bestrahlen von zu detektierenden Partikeln sowie einen dafür spektral empfindlichen gemeinsamen Photosensor auf. Die beiden Leuchtdioden weisen jeweils eine Sendeachse und der Photosensor eine Empfangsachse auf. Beide Leuchtdioden sowie der Photosensor sind derart zueinander angeordnet und ausgerichtet, dass alle drei Achsen in einer gemeinsamen Ebene liegen. Die erste Leuchtdiode ist mit dem Photosensor unter einem Vorwärtsstreuwinkel und die zweite Leuchtdiode mit dem Photosensor unter einem Rückwärtsstreuwinkel angeordnet.

Die Erfindung betrifft einen (weiteren) Streulichtrauchmelder mit einer nach dem Streulichtprinzip arbeitenden Detektionseinheit. Letztere weist eine (einzige) Leuchtdiode zum Bestrahlen von zu detektierenden Partikeln sowie einen dafür spektral empfindlichen ersten und zweiten Photosensor auf. Die beiden Photosensoren weisen jeweils eine Empfangsachse und die Leuchtdiode eine Sendeachse auf. Beide Photosensoren sowie die Leuchtdiode sind derart zueinander angeordnet und ausgerichtet, dass alle drei Achsen in einer gemeinsamen Ebene liegen. Der erste Photosensor ist mit der Leuchtdiode unter einem Vorwärtsstreuwinkel und der zweite Photosensor mit der Leuchtdiode unter einem Rückwärtsstreuwinkel angeordnet.

Derartige Rauchmelder werden auch als Brandmelder bezeichnet. Sie weisen typischerweise ein Meldergehäuse mit zumindest einer Raucheintrittsöffnung sowie eine im Meldergehäuse aufgenommene Detektionseinheit für die Rauchdetektion auf. Die Detektionseinheit umfasst vorzugsweise eine gegen Umgebungslicht abgeschirmte, jedoch für zu detektierenden Rauch durchlässige optische Messkammer. Letztere weist üblicherweise eine Vielzahl von Umgebungslicht abschirmenden Lamellen auf und wird daher auch als Labyrinth bezeichnet.

Mit der jeweiligen Leuchtdiode und dem jeweiligen Photosensor ist eine Steuereinheit als Teil des Rauchmelders verbunden. Die Steuereinheit ist dazu eingerichtet, eine Warnmeldung und/oder eine Alarmmeldung auszugeben, falls ein jeweiliger Mindestkonzentrationswert von Rauch detektierbar ist.

Aus dem Stand der Technik, wie z.B. aus der EP 0 877 345 A2 oder aus der WO 2005/043479 A1, sind weiterhin Rauchmelder bekannt, die zwei Leuchtdioden mit unterschiedlicher Farbe sowie einen Photosensor in einer oder in zwei Streulichtanordnungen einsetzen. Zur Aussendung des roten oder infraroten Lichts ist der Einsatz einer rotleuchtenden LED oder einer Infrarot-LED, zur Aussendung von blauem oder violettem Licht der Einsatz einer blau- bzw. violettleuchtenden LED bekannt. Durch geeignete Auswertung des vom Photosensor empfangenen jeweiligen farbigen Streulichts, wie z.B. durch Verhältnisbildung, ist dann eine Auswertung hinsichtlich der Partikelgrösse der detektierten Rauchpartikel möglich. Mittels geeigneter Bewertung der ermittelten Partikelgrössen ist z.B. eine Unterscheidung von Rauch, Staub und Wasserdampf möglich. Die Ausgabe eines möglichen Fehlalarms wird dadurch vermieden.

Aus der EP 1 408 469 A2 ist weiterhin ein Streulicht-Brandmelder bekannt, der zwei einfarbige LEDs und zwei Fotoempfänger aufweist. Der Melder umfasst eine mit der Umgebungsluft kommunizierende Messkammer auf, die ein Messvolumen begrenzt, in das eine infrarotstrahlende und eine blaustrahlende LED aus unterschiedlichen Richtungen einstrahlen. Die an den im Messvolumen befindlichen Partikeln gestreute Strahlung wird fotoelektrisch gemessen und ausgewertet.

Bekannt ist aus dem Stand der Technik auch der Einsatz zweier nebeneinander angeordneter einfarbiger Leuchtdioden, deren ausgesandtes Licht z.B. über ein Y-förmiges optisches Sammelelement oder mittels zweier zusammengeführter Lichtleiter auf eine gemeinsame optische Achse zusammengeführt wird.

Die betrachteten Rauchmelder sind typischerweise zum Betrieb an einer Melderlinie mit einer Vielzahl weiterer daran angeschlossener Rauchmelder oder zum batteriegestützten Stand-Alone-Betrieb eingerichtet.

Aus der noch unveröffentlichten Europäischen Patentanmeldung 14155048.3 der Anmelderin ist die Verwendung einer einzigen Leuchtdiode mit zwei nebeneinander angeordneten LED-Chips mit unterschiedlichen Farben bekannt. Der erste Chip sendet vorzugsweise rotes oder infrarotes Licht aus. Der zweite Chip sendet vorzugsweise blaues oder ultraviolettes Licht aus.

Ausgehend von dem eingangs genannten Stand der Technik ist es eine Aufgabe der Erfindung, einen Rauchmelder mit einer verbesserten Detektionseinheit anzugeben.

Die Aufgabe wird mit den Gegenständen des Hauptanspruchs 1 und 2 gelöst. Vorteilhafte Ausführungsformen der vorliegenden Erfindung sind in den abhängigen Ansprüchen angegeben.

Den beiden Hauptansprüchen liegt die gemeinsame Idee zugrunde, dass auch mit nur drei einstückigen optoelektronischen Bauelementen in einer Vorwärts- und Rückwärtsstreulichtanordnung eine zuverlässige Unterscheidung zwischen Rauch, Staub und Wasserdampf bei der Rauchdetektion möglich ist.

Gemäss Hauptanspruch 1 weisen die beiden Leuchtdioden erfindungsgemäss jeweils einen ersten und zweiten LED-Chip zum Aussenden eines jeweiligen ersten und zweiten Lichtbündels mit Licht in einem ersten und in einem davon verschiedenen zweiten Wellenlängenbereich auf.

Gemäss Hauptanspruch 2 weist die Leuchtdiode einen ersten und zweiten LED-Chip zum Aussenden eines ersten und zweiten Lichtbündels mit Licht in einem ersten und in einem davon verschiedenen zweiten Wellenlängenbereich auf.

Bei der zweifarbigen Leuchtdiode bzw. bei beiden zweifarbigen Leuchtdioden handelt es sich jeweils um ein einstückiges bzw. einteiliges optoelektronisches Bauelement, mit anderen Worten also um jeweils eine Baueinheit. Vorzugsweise ist eine solche zweifarbige Leuchtdiode eine Leuchtdiode mit einem transparenten (Standard-)Gehäuse mit einem Durchmesser von 3 mm oder 5 mm. Derartige 3 mm- oder 5 mm-Leuchtdioden werden bekanntermassen "off the shelf" als massenhaftes Consumerprodukt verkauft.

Je nach Konfiguration der erfindungsgemässen Detektionseinheit sind beide zweifarbigen Leuchtdioden oder beide Photosensoren vorzugsweise typgleiche Bauelemente.

Alternativ kann anstelle einer der beiden zweifarbigen Leuchtdioden eine einfarbige Leuchtdiode, wie z.B. mit nur einem ersten oder zweiten LED-Chip, eingesetzt werden. In diesem Fall ist diese Leuchtdiode eine IR-LED, eine rotleuchtende LED, eine rot/orangeleuchtende LED, eine blaugrün, grün, blau oder ultraviolett leuchtende LED.

Der besondere Vorteil ist, dass im Vergleich zur Detektionseinheit gemäss der EP 1 408 469 A2 anstelle von vier (einteiligen) optoelektronischen Bauelementen nur drei (einteilige) optoelektronische Bauelementen benötigt werden.

Neben der Ersparnis eines Bauelements ist vorteilhaft der Aufwand für die Kalibrierung des optischen Pfads in der Detektionseinheit reduziert. Typischerweise erfordern die bei der Montage von zwei separaten Leuchtdioden auftretenden relativen Abweichungen in Ausrichtung und Platzierung zueinander eine aufwändige Kalibrierung.

Ein weiterer Vorteil liegt darin, dass durch den nun möglichen Entfall der vierten Komponente eine optisch streuende

Störgrösse entfällt. An der Stelle der sonst vierten Komponenten können weitere lichtabsorbierende oder lichtweglenkende Komponenten als Lichtfalle in der Detektionseinheit eingesetzt werden. Dadurch reduziert sich der messtechnisch störende Grundimpuls erheblich.

Die beiden LED-Chips sind vorzugsweise als Flächenstrahler ausgebildet. Mit "Flächenstrahler" ist hier gemeint, dass das Licht aus einer ebenen Fläche mit einer Lambert' schen Lichtverteilung abgestrahlt wird. Die Flächenstrahler können somit auch als Lambert-Strahler bezeichnet werden. Alternativ können die LED-Chips als Kantenstrahler ausgebildet sein, wobei dann die Hauptabstrahlrichtung des jeweiligen Kantenstrahlers parallel zur optischen Sendeachse der Leuchtdiode ist.

Der erste LED-Chip emittiert vorzugsweise Licht im blaugrünen, blauen, violetten oder ultravioletten Bereich, und der zweite LED-Chip Licht im rot/orangen, roten oder infraroten Bereich.

Die LED-Chips stammen üblicherweise aus einem Wafer mit einer Vielzahl in einem optoelektronischen Halbleiterprozess hergestellter LED-Chips. Ein solcher Wafer wird durch mechanische Trennprozesse, insbesondere durch Sägen oder Brechen, in die Vielzahl der LED-Chips zerlegt. Ein solches "nacktes" und für sich vollständig funktionsfähiges Bauteil wird auch als "Die" bezeichnet. Es weist daher eine typischerweise quadratische oder auch rechteckige Form auf.

Nach einer bevorzugten Ausführungsform liegt das Verhältnis der optisch aktiven Oberfläche des jeweilige ersten LED-Chips zu der optisch aktiven Oberfläche des jeweiligen zweiten LED-Chips bei der jeweiligen Leuchtdiode in einem Bereich von 1.3 bis 12, insbesondere in einem Bereich von 2.5 bis 6.5.

Mit "optisch aktiv" sind die Teile der Oberfläche der LED-Chips gemeint, die bei Stromerregung Licht emittieren. Bereiche für die Kontaktierung der LED-Chips auf der Oberfläche, die z.B. zur Kontaktierung eines Bonddrahts bestimmt sind, gehören somit nicht dazu.

Dadurch ist über das Flächenverhältnis vorteilhaft eine Anpassung des jeweilig spektral unterschiedlichen Wirkungsgrads bei der Erzeugung von Licht im ersten und im zweiten Wellenlängenbereich möglich. Typischerweise ist die Erzeugung von blauem bzw. violettem Licht in etwa um den Faktor 10 schlechter als die Erzeugung von rotem bzw. infrarotem Licht. Für die Erzeugung von blauem Licht mit einer Wellenlänge von 470 nm (LED-Typ SFH4570 von OSRAM) ist somit ca. die 11-fache optisch aktive Oberfläche für eine gleiche Bestrahlungsstärke erforderlich wie für die Erzeugung von infrarotem Licht mit einer Wellenlänge von 940 nm (LED-Typ SFH4550 von OSRAM).

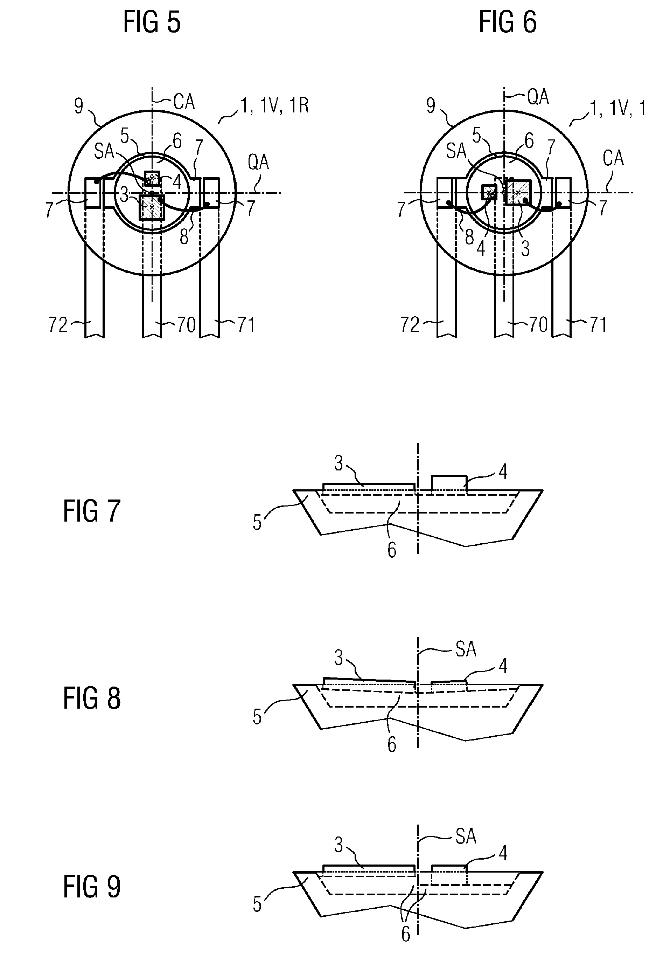

Hinzu kommt die deutlich schlechtere spektrale Empfindlichkeit von blauem Licht bei Silizium-PIN-Photodioden, die üblicherweise als Photosensoren eingesetzt werden. So ist unter Annahme der zuvor beschriebenen beispielhaften OSRAM-LEDs die Detektion des blauen Lichts um den Faktor 1.7 schlechter als die Detektion des infraroten Lichts (siehe dazu FIG 5). Für die gesamte elektrisch-optisch-elektrische Wirkungsgradkette resultiert in Summe sogar ein Faktor von ca. 19 = 11 x 1.7.

Folglich kann die optisch aktive Oberfläche des "blauleuchtenden" LED-Chips so bemessen werden, dass ein qualitativ ausreichendes Photosensorsignal für eine zuverlässige Rauchdetektion gewährleistet ist. Dagegen kann wegen des erheblich besseren elektrisch-optisch-elektrischen Wirkungsgrades des "roten" Anteils die Oberfläche des "roten" LED-Chips für die Erzeugung des roten bzw. infraroten Lichts auf einen Bruchteil reduziert werden. Dadurch reduzieren sich vorteilhaft der elektrische Leistungsbedarf sowie die Kosten für eine derartige zweifarbige LED.

Nach einer weiteren Ausführungsform weist die jeweilige Leuchtdiode einen orthogonal zu ihrer Sendeachse angeordneten LED-Chipträger auf. Die jeweiligen beiden LED-Chips sind nebeneinander auf dem LED-Chipträger angeordnet. Die jeweilige Leuchtdiode ist derart um ihre Sendeachse gedreht zum Photosensor ausgerichtet, dass eine durch beide LED-Chips verlaufende jeweilige Chipachse orthogonal und/oder parallel zur gemeinsamen Ebene verläuft.

Für den Fall einer einzigen zweifarbigen LED und zweier Photosensoren kann deren Chipachse orthogonal oder parallel zur gemeinsamen Ebene verlaufen. Im orthogonalen Fall sind dann beide von den LED-Chips ausgesandten Lichtbündel vorteilhaft unter einem gleichen Streulichtwinkel detektierbar. Dadurch sind die beiden Photosensor in messtechnischer Hinsicht besser vergleichbar. Im parallelen Fall und insbesondere dann, wenn das vom zweiten LED-Chip ausgesandte Lichtbündel mehr in Richtung zum Photosensor gerichtet ist als das erste Lichtbündel, wird der hinsichtlich der Wirkungsgradkette schlechtere Lichtanteil deutlich bevorzugt.

Für den Fall zweier zweifarbiger LED mit gemeinsamen Photosensor sind in Summe vier Möglichkeiten für die orthogonale und/oder parallele Ausrichtung der beiden Chipachsen möglich.

Vorzugsweise sind die jeweiligen beiden LED-Chips derart nebeneinander angeordnet, dass ihre jeweilige geometrische Mitte einen gleichen Abstand zur Sendeachse aufweist.

Dadurch liegt das jeweilige Abstrahlmaximum der beiden LED-Chips symmetrisch zur Sendeachse. Die geometrische Mitte liegt z.B. im Fall von LED-Chips mit quadratischer oder rechteckiger Form im Schnittpunkt zweier Flächendiagonalen.

Nach einer weiteren Ausführungsform ist der jeweilige erste LED-Chip zum Aussenden von Licht im Wellenlängenbereich von 350 nm bis 500 nm ausgebildet. Der jeweilige zweite LED-Chip ist zum Aussenden von Licht im Wellenlängenbereich von 665 nm bis 1000 nm ausgebildet. Dabei ist die Rauchteilchengrösse umso genauer bestimmbar, je grösser der Abstand der beiden Wellenlängenbereiche voneinander ist. Insbesondere ist dann der erste LED-Chip zum Aussenden von Licht mit einer Wellenlänge von 460 nm ± 40 nm oder 390 nm ± 40 nm und der zweite LED-Chip zum Aussenden von Licht mit einer Wellenlänge von 940 nm ± 40 nm oder 860 nm ± 40 nm ausgebildet.

Nach einer Ausführungsform weist die jeweilige Leuchtdiode ein Gehäuse aus einem insbesondere transparenten Kunststoff auf. Das Gehäuse bildet in einem Bereich zwischen dem Lichtaustritt aus den jeweiligen beiden LED-Chips und dem Lichtaustritt an der Aussenseite des Gehäuses eine optische Linse aus. Mit "transparent" ist hier gemeint, dass das Kunststoff- oder auch Glasgehäuse zumindest für das vom ersten und zweiten LED-Chip stammende emittierte Licht durchlässig ist.

Einer weiteren Ausführungsform zufolge ist die jeweilige Leuchtdiode und/oder der jeweilige Photosensor ein SMD-Bauelement oder ein Bauelement für eine Durchlochmontage. Eine derartige zweifarbige SMD-Leuchtdiode umfasst gleichfalls ein transparentes Kunststoff- oder Glasgehäuse. Als SMD-Bauelement ist sie für die direkte Oberflächenmontage auf einem Schaltungsträger ausgebildet. Der SMD-Leuchtdiode wie auch der Leuchtdiode für die Durchlochmontage können auch ein Lichtleiter oder ein Spiegel optisch nachgeschaltet sein, welche die ausgesandten Lichtbündel z.B. um 90° umlenken.

Die beiden LED-Chips sind orthogonal zur Sendeachse, also zur optischen Hauptachse der Leuchtdiode auf dem Chipträger ausgerichtet. Mit anderen Worten verläuft die Flächennormale des insbesondere planen Chipträgers parallel zur Sendeachse. Die beiden LED-Chips sind nebeneinander auf dem LED-Chipträger und folglich auch plan auf dem LED-Chipträger angeordnet. Ihre jeweiligen Flächennormalen verlaufen gleichfalls parallel zur optischen Hauptachse der Leuchtdiode.

Der LED-Chipträger muss nicht notwendiger plan ausgeführt sein. Er kann auch zwei leicht zueinander geneigte Teilflächen im Sinne einer Kerbe aufweisen, die jeweils einen LED-Chip aufnehmen. Dadurch werden die beiden ausgesandten Lichtbündel aufeinander zu ausgerichtet (siehe FIG 8). Der Chipträger kann auch zwei ebene Teilflächen mit gleicher Orientierung aufweisen, aber durch eine Stufe voneinander getrennt sind. Die Stufung kann so gewählt sein, dass bei unterschiedlicher Bauteildicke der beiden LED-Chips die optisch aktiven Flächen in einer gemeinsamen Ebene liegen (siehe FIG 9).

Nach einer Ausführungsform weist der Rauchmelder eine mit der jeweiligen Leuchtdiode und mit dem jeweiligen Photosensor verbundene elektronische Steuereinheit auf. Die Steuereinheit ist dazu eingerichtet, eine Warnmeldung und/oder eine Alarmmeldung auszugeben, falls ein Mindestkonzentrationswert von Rauch detektierbar ist. Die Steuereinheit ist vorzugsweise ein Mikrocontroller. Sie ist dazu eingerichtet, je nach Konfiguration der Detektionseinheit entweder die beiden LED-Chips der einzigen Zweifarben-LED zum Aussenden des jeweiligen Lichts elektrisch anzusteuern und dazu synchronisiert das jeweilige elektrische Signal von beiden Photosensoren zu erfassen und auszuwerten. Oder die Steuereinheit ist dazu eingerichtet, beide LED-Chips der beiden Zweifarben-LEDs zum Aussenden des jeweiligen Lichts elektrisch anzusteuern und dazu synchronisiert das elektrische Signal vom gemeinsamen Photosensor zu erfassen und auszuwerten. Durch Differenzbildung oder Verhältnisbildung aus den beiden jeweiligen, der "Farbe" zugeordneten empfangenen Signalamplituden des Photosensors bzw. der beiden Photosensoren und in Abhängigkeit vom jeweiligen Streuwinkel ist dann eine Bestimmung der Partikelgrösse und des Partikeltyps wie Rauch, Staub oder Dampf möglich. Durch Vergleich vorzugsweise des "blauen" Signals mit einem jeweiligen Mindestkonzentrationswert ist eine Warnmeldung und/oder eine Alarmmeldung ausgebbar. Die jeweiligen Verarbeitungsschritte für die zeitliche Ansteuerung der beiden LED-Chips sowie die synchronisierte Erfassung und Auswertung des jeweiligen Photosensorsignals können durch geeignete, auf dem Mikrocontroller ausführbare Programmschritte realisiert sein.

Einer weiteren Ausführungsform zufolge ist der jeweilige Photosensor eine Halbleiter-Photodiode, insbesondere eine Silizium-PIN-Photodiode. Sie ist vorzugsweise eine Silizium-PIN-Photodiode mit verbesserter Blauempfindlichkeit.

Weiterhin sind gemäss einer weiteren Ausführungsform beide LED-Chips der jeweiligen Leuchtdiode durch die elektronische Steuereinheit abwechselnd gepulst oder gleichzeitig gepulst ansteuerbar. Im ersten Fall ist lediglich ein Photosensor erforderlich. Im zweiten Fall können zwei Photosensoren für das jeweilige zu detektierende Streulicht erforderlich sein.

Die Steuereinheit kann zudem dazu eingerichtet sein, den jeweiligen ersten LED-Chip mit seinem spezifizierten Nennstrom anzusteuern. Die Steuereinheit kann weiterhin dazu eingerichtet sein, den jeweiligen zweiten LED-Chip mit einem im Vergleich zu seinem spezifizierten Nennstrom festlegbaren Reduktionsfaktor anzusteuern.

Mit "spezifizierten Nennstrom" ist hier der vom Leuchtdiodenhersteller typischerweise in einem Datenblatt spezifizierte Nennstromwert gemeint. Dadurch ist vorteilhaft eine Reduktion der für den Betrieb des zweiten LED-Chips erforderlichen elektrischen Leistung möglich. Grund hierfür ist eine fertigungs- und montagetechnisch bedingte Mindestchipgrösse für den zweiten LED-Chip, das heisst für den rotleuchtenden LED-Chip. Durch den Reduktionsfaktor, der typischerweise im Bereich zwischen 2 bis 4 liegt, wird sozusagen eine "elektronische Verkleinerung" der Chipfläche des zweiten LED-Chips bewirkt. Darüber hinaus ist über diesen Reduktionsfaktor auch eine Kalibrierung der Ansteuerung für den ersten und zweiten LED-Chip vorteilhaft möglich. Die Stromreduktion und somit auch die Leistungsreduktion kann z.B. mittels einer pulsweitenmodulierten Ansteuerung des zweiten LED-Chips erfolgen. Dabei entspricht der Reduktionsfaktor im Bereich von 2 bis 4 dem Tastverhältnis der Pulsweitenmodulation. Die Ansteuerfrequenz liegt vorzugsweise im Bereich von 100 kHz bis 10 MHz. Vorzugsweise ist der Reduktionsfaktor durch die unterschiedliche spektrale Empfindlichkeit des Photosensors für zu detektierendes gestreutes Licht im ersten und zweiten Wellenlängenbereich festgelegt.

Für den Fall einer Detektionseinheit mit zwei zweifarbigen Leuchtdioden und einem gemeinsamen Photosensor, bei dem die erste Leuchtdiode mit dem Photosensor unter einem Vorwärtsstreuwinkel und die zweite Leuchtdiode mit dem Photosensor unter einem Rückwärtsstreuwinkel angeordnet ist, liegt der Vorwärtsstreuwinkel in einem Bereich von 20° bis 90°, insbesondere in einem Bereich von 30° bis 70°. Der Rückwärtstreuwinkel liegt in einem Bereich von mehr als 90° bis 160°, insbesondere in einem Bereich von 110° bis 150°. Im Besonderen liegt der Vorwärtsstreuwinkel bei 60° und der Rückwärtsstreuwinkel bei 120°.

Für den Fall einer Detektionseinheit mit zwei Photosensoren und einer einzigen zweifarbigen Leuchtdiode, bei dem der erste Photosensor mit dieser Leuchtdiode unter einem Vorwärtsstreuwinkel und der zweite Photosensor mit dieser Leuchtdiode unter einem Rückwärtsstreuwinkel angeordnet ist, liegt der Vorwärtsstreuwinkel in einem Bereich von 20° bis 90°, insbesondere in einem Bereich von 30° bis 70°. Der Rückwärtstreuwinkel liegt in einem Bereich von mehr als 90° bis 160°, insbesondere in einem Bereich von 110° bis 150°. Im Besonderen liegt der Vorwärtsstreuwinkel bei 60° und der Rückwärtsstreuwinkel bei 120°.

Die Erfindung sowie vorteilhafte Ausführungen der vorliegenden Erfindung werden am Beispiel der nachfolgenden Figuren erläutert. Dabei zeigen:
- FIG 1: eine beispielhafte nach dem Streulichtprinzip arbeitende erste Ausführungsform einer Detektionseinheit für einen Rauchmelder mit zwei zweifarbigen Leuchtdioden und mit einem Photoempfänger gemäss der Erfindung,
- FIG 2: eine zweite Ausführungsform mit zwei zweifarbigen Leuchtdioden und mit einem Photoempfänger gemäss der Erfindung,
- FIG 3: eine dritte Ausführungsform mit zwei Photoempfängern und mit einer einzigen gemeinsamen zweifarbigen Leuchtdiode gemäss der Erfindung,
- FIG 4: eine vierte Ausführungsform mit zwei Photoempfängern und mit einer einzigen gemeinsamen zweifarbigen Leuchtdiode gemäss der Erfindung,
- FIG 5: eine Aufsicht auf eine zweifarbige Leuchtdiode mit zwei LED-Chips in einer ersten Ausführungsform,
- FIG 6: eine Aufsicht auf eine zweifarbige Leuchtdiode mit zwei LED-Chips in einer zweiten Ausführungsform,
- FIG 7 - FIG 9: verschiedene Ausführungen eines LED-Chipträgers mit zwei aufgenommenen LED-Chips,
- FIG 10: ein Beispiel für einen erfindungsgemässen Streulichtrauchmelder mit einer im Inneren angeordneten, für Rauch durchlässigen, jedoch gegenüber Umgebungslicht abgeschirmten Detektionseinheit, und
- FIG 11: ein Beispiel für die spezifische spektrale Empfindlichkeit einer Silizium-PIN-Photodiode mit erhöhter Blauempfindlichkeit.

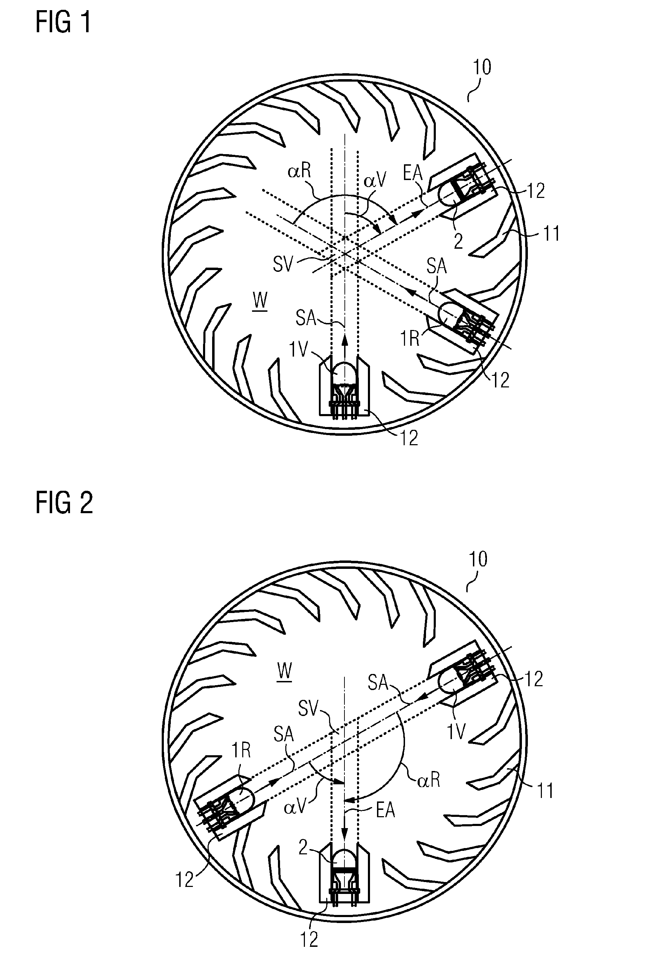

FIG 1 zeigt eine beispielhafte nach dem Streulichtprinzip arbeitende erste Ausführungsform einer Detektionseinheit 10 für einen Rauchmelder 100 mit zwei zweifarbigen Leuchtdioden 1V, 1R und mit einem Photoempfänger 2 gemäss der Erfindung.

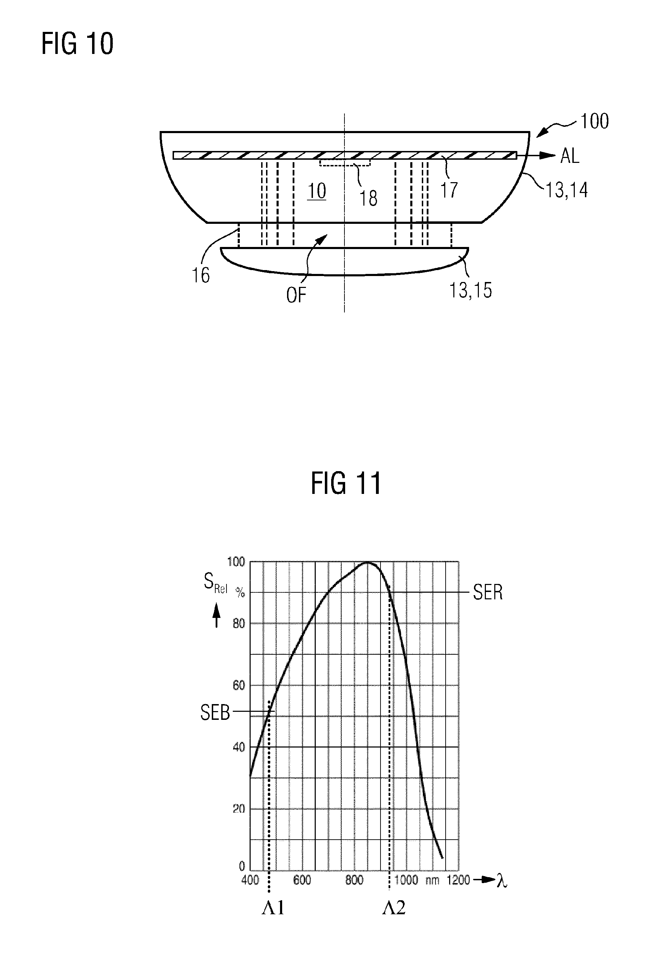

Aus Gründen der Übersichtlichkeit ist ein die Detektionseinheit 10 umgebendes Rauchmeldergehäuse nicht dargestellt (siehe dazu FIG 11). Ebenso wurde auf die Darstellung eines typischerweise im Rauchmeldergehäuse aufgenommenen Schaltungsträgers mit Steuereinheit sowie auf die Darstellung von Raucheintrittsöffnungen im Rauchmeldergehäuse verzichtet.

Die Detektionseinheit 10 weist eine optische Messkammer mit einer Vielzahl von Umgebungslicht abschirmenden Lamellen 11 auf. Die Lamellen 11 sind in Umfangsrichtung so angeordnet, dass im Wesentlichen sämtliches direktes Licht von den beiden Leuchtdioden 1V, 1R sowie Streulicht in die Zwischenräume der Lamellen 11 gelenkt wird. Das dort einfallende Licht "verfängt" sich dann dort unter mehrmaliger abschwächender Hin- und Her-Reflexion im Sinne einer Lichtfalle.

Im Inneren der Detektionseinheit 10 sind gemäss der Erfindung zwei bau- bzw. typgleiche zweifarbige Leuchtdioden 1V, 1R sowie ein dafür spektral empfindlicher gemeinsamer Photosensor 2 dargestellt. Beide Leuchtdioden 1V, 1R weisen jeweils eine Sendeachse SA und der Photosensor 2 eine Empfangsachse EA auf. Alle drei optischen Achsen SA, EA liegen in einer gemeinsamen Ebene W.

Alle drei optoelektronischen Bauelemente 1V, 1R, 2 weisen ferner Blenden 12 auf, sodass kein direktes ausgesandtes Licht von den Leuchtdioden 1V, 1R zu dem Photosensor 2 gelangt. Durch die Blenden 12 ist optisch konstruktiv der jeweilige Sendebereich der Leuchtdioden 1V, 1R sowie der Empfangsbereich des Photosensors 2 festgelegt. Die gemeinsame Schnittmenge bzw. das Schnittvolumen bildet dann das sogenannte Streuvolumen SV für die optische Rauchdetektion. Im Inneren der Detektionseinheit 10 können noch weitere Blenden vorhanden sein, wie z.B. eine Lochblende, oder optische Mittel wie Linsen.

Im vorliegenden Beispiel ist die erste Leuchtdiode 1V unter einem Vorwärtstreuwinkel αV von 60° zum Photosensor 2 angeordnet. Die zweite Leuchtdiode 1R ist unter einem Rückstreuwinkel αR von 120° zu demselben Photosensor 2 angeordnet. Konstruktiv betrachtet sind die beiden Streuwinkel αV, αR durch den Schnittpunkt der jeweiligen Sendeachse SA und der Empfangsachse EA des gemeinsamen Photosensors 2 festgelegt. Die beiden Schnittpunkte sind dabei identisch. In praktischer Hinsicht müssen sich nicht alle optischen Achsen SA, EA in diesem einen Schnittpunkt schneiden. Geringfügige Winkelabweichungen untereinander von wenigen Grad, insbesondere von weniger als 1° können in der Praxis unberücksichtigt bleiben.

Beide Leuchtdioden 1V, 1R weisen jeweils einen ersten und zweiten LED-Chip 3, 4 auf. Der jeweilige erste LED-Chip 3 ist zum Aussenden eines ersten Lichtbündels BL mit Licht in einem ersten Wellenlängenbereich ausgebildet. Im vorliegenden Beispiel emittiert der erste LED-Chip 3 bei elektrischer Erregung monochromatisches blaues Licht bei einer Wellenlänge von 460 nm ± 40 nm. Der zweite LED-Chip 4 emittiert bei elektrischer Erregung monochromatisches infrarotes Licht bei einer Wellenlänge von 940 nm ± 40 nm. Die Leuchtdioden 1V, 1R weisen ein Kunststoffgehäuse auf, welches eine optische Linse zur Lichtbündelung des von der jeweiligen Leuchtdiode 1V, 1R erzeugten Lichts in Richtung zum Streuvolumen SV ausbildet. Die beiden Leuchtdioden 1V, 1R sowie der Photosensor 2 entsprechen in ihrem äusseren Erscheinungsbild dem einer typischen 5 mm-Leuchtdiode für eine "Through-Hole-Montage" mit einem Durchmesser des Kunststoffgehäuses von 5 mm. Alternativ kann diese eine 3 mm-Leuchtdiode sein.

Beide Bauelemente 1V, 1R, 2 sind typischerweise elektrisch mit einem Schaltungsträger verbunden, der sich üblicherweise ausserhalb der Detektionseinheit 10 befindet und der an diese angrenzt. Auf dem Schaltungsträger können weitere Bauelemente angeordnet sein wie z.B. ein Mikrocontroller, aktive oder passive Bauelemente.

Die erfindungsgemässe Anordnung aus den beiden zweifarbigen Leuchtdioden 1V, 1R, die unter einem Vorwärtsstreuwinkel αV und unter einem Rückwärtstreuwinkel αR mit dem gemeinsamen Photosensor 2 angeordnet und ausgerichtet sind, erlaubt bei nur drei optischen Bauelementen 1V, 1R, 2 eine zuverlässige Rauchdetektion. Zur messtechnischen Auswertung stehen somit Streulichtsignale mit zwei verschiedenen "Farben" bei zwei verschiedenen Streuwinkeln αV, αR zur Verfügung.

FIG 2 zeigt eine zweite Ausführungsform mit zwei zweifarbigen Leuchtdioden 1V, 1R und mit einem Photoempfänger 2 gemäss der Erfindung. Im Vergleich zur vorherigen Ausführungsform liegen die beiden Sendeachsen SA der Leuchtdioden 1V, 1R nun auf einer gemeinsamen optischen Achse. Das Streuvolumen SV ist hier im Vergleich zur vorherigen Ausführungsform für beide "Farben" sogar identisch. Dagegen wirkt die jeweils gegenüberliegende Leuchtdiode 1V, 1R wie ein optischer Streukörper, was für eine messtechnische Auswertung ungünstiger ist.

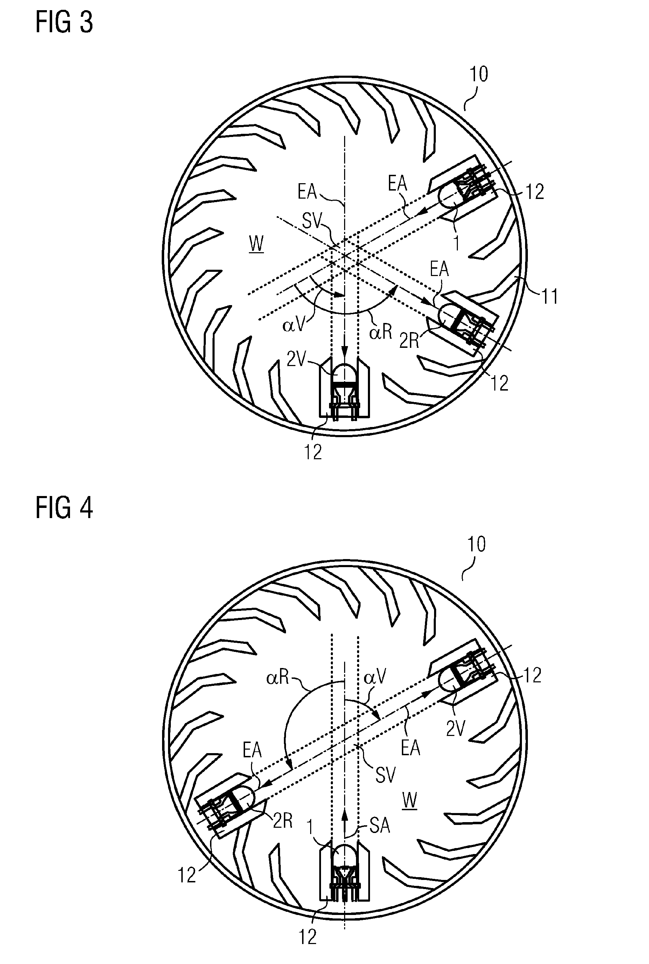

FIG 3 zeigt eine dritte Ausführungsform mit zwei Photoempfängern 2V, 2R und mit einer einzigen gemeinsamen zweifarbigen Leuchtdiode 1 gemäss der Erfindung.

Auch diese erfindungsgemässe Anordnung aus zwei Photosensoren 2V, 2R und einer gemeinsamen zweifarbigen Leuchtdiode 1, die unter einem Vorwärtsstreuwinkel αV und unter einem Rückwärtstreuwinkel αR mit dem jeweiligen Photosensor 2V, 2R angeordnet und ausgerichtet ist, erlaubt bei nur drei optischen Bauelementen 2V, 2R, 1 eine zuverlässige Rauchdetektion. Zur messtechnischen Auswertung stehen auch hier Streulichtsignale mit zwei verschiedenen "Farben" bei zwei verschiedenen Streuwinkeln αV, αR zur Verfügung.

FIG 4 zeigt eine vierte Ausführungsform mit zwei Photoempfängern 2V, 2R und mit einer einzigen gemeinsamen zweifarbigen Leuchtdiode 1 gemäss der Erfindung.

Im Vergleich zur vorherigen Ausführungsform liegen die beiden Empfangsachsen EA der Photosensoren 2V, 2R nun auf einer gemeinsamen Achse. Das Streuvolumen SV ist hier im Vergleich zur vorherigen Ausführungsform für beide "Farben" identisch. Dagegen wirkt ein jeweiliger gegenüberliegender Photosensor 2V, 2R für den anderen wie ein optischer Streukörper, was auch hier für eine messtechnische Auswertung ungünstiger ist.

FIG 5 zeigt eine Aufsicht auf eine zweifarbige Leuchtdiode 1, 1V, 1R mit zwei LED-Chips 3, 4 in einer ersten Ausführungsform.

Mit dem Bezugszeichen 9 ist ein Kunststoffgehäuse bezeichnet, in dem der LED-Chipträger 6 als Teil eines Reflektors 5 mit den beiden LED-Chips 3, 4 eingegossen ist. Der Reflektor 5 ist zugleich als gemeinsamer Anschlusskontakt 7 ausgebildet und als mittlerer Anschlusskontakt 70 aus dem Gehäuse 9 herausgeführt. Der mittlere Anschlusskontakt 70 ist zu beiden Seiten durch einen ersten und zweiten Anschlusskontakt 71, 72 umgeben, die zur elektrischen Verbindung mit den beiden LED-Chips 3, 4 vorgehen sind. Die beiden Anschlusskontakte 71, 72 bilden im Bereich des LED-Chipträgers 6 jeweils eine Kontaktierungsfläche zur Kontaktierung der beiden LED-Chips 3, 4 mit diesen über Bonddrähte 8 aus.

Die Leuchtdiode 1, 1V, 1R weist einen orthogonal zu ihrer Sendeachse SA angeordneten LED-Chipträger 6 auf. Der Chipträger 6 ist plattenförmig und plan ausgebildet. Mit anderen Worten ist die Flächennormale des LED-Chipträgers 6 parallel zur Sendeachse SA. Die beiden LED-Chips 3, 4 sind zudem nebeneinander auf dem LED-Chipträger 6 angeordnet. Die gezeigte Leuchtdiode 1, 1V, 1R ist derart um ihre Sendeachse SA gedreht zum Photosensor ausgerichtet, dass eine durch beide LED-Chips 3, 4 verlaufende Chipachse CA orthogonal zur gemeinsamen Winkelebene W verläuft. Mit QA ist eine Querachse bezeichnet, die jeweils orthogonal zur Chipachse CA und zur Sendeachse SA ist.

Durch die "Übereinanderanordnung" der beiden LED-Chips 3, 4 werden die beiden farbigen Streulichtsignale aus Sicht des gemeinsamen Photosensors bzw. aus Sicht beider Photosensoren unter einem gleichen Streulichtwinkel empfangen.

Wie die FIG 5 weiter zeigt, liegt das Verhältnis der optisch aktiven Oberfläche des ersten LED-Chips 3 zu der optisch aktiven Oberfläche des zweiten LED-Chips 4 in einem Bereich von 1.3 bis 12, insbesondere in einem Bereich von 2,5 bis 6,5. Im vorliegenden Beispiel liegt das Verhältnis bei etwa 2.78 =(0.5 x 0.5 mm)² / (0.3 x 0.3 mm)², wobei die Seitenlänge der beiden beispielhaft quadratischen LED-Chips 3, 4 eine Kantenlänge von 0.5 mm bzw. 0.3 mm aufweisen. Zudem sind die beiden LED-Chips 3, 4 bereits derart nebeneinander angeordnet, dass die jeweilige geometrische Mitte der beiden LED-Chips 3, 4 einen gleichen Abstand zur Sendeachse SA der Leuchtdiode 1, 1V, 1R aufweist. Die jeweilige geometrische Mitte ist durch ein kleines "x" eingezeichnet.

Die Kanten der beiden LED-Chips 3, 4 sind vorzugsweise parallel und orthogonal zueinander ausgerichtet. Insbesondere sind die beiden LED-Chips 3, 4 dann mittig, also zentriert zueinander angeordnet. Dies zeigt bereits die vorliegende FIG 5. In einem solchen Fall lässt sich die Chipachse CA auch als Gerade definieren bzw. festlegen, die sowohl durch die geometrische Mitte des ersten LED-Chips 3 als auch durch die Mitte des zweiten LED-Chips 4 verläuft. Im gezeigten idealen Fall der FIG 5 sind die beiden LED-Chips 3, 4 derart zueinander ausgerichtet und auf dem Chipträger 6 angeordnet, dass die Chipachse CA zudem noch durch die Sendeachse SA der Leuchtdiode 1, 1V, 1R verläuft.

FIG 6 zeigt eine Aufsicht auf eine zweifarbige Leuchtdiode 1, 1V, 1R mit zwei LED-Chips 3, 4 in einer zweiten Ausführungsform. In diesem Fall ist die jeweilige Leuchtdiode 1, 1V, 1R derart um ihre Sendeachse SA gedreht zum Photosensor ausgerichtet, dass eine durch beide LED-Chips 3, 4 verlaufende Chipachse CA parallel zur gemeinsamen Winkelebene W verläuft.

FIG 7 zeigt einen planen LED-Chipträger 6 mit zwei darauf benachbart angeordneten LED-Chips 3, 4. Dabei weist der "rote" LED-Chip 4 im Vergleich zum "blauen" LED-Chip 3 eine grössere Bauteildicke auf.

Die FIG 8 und FIG 9 zeigen, dass der LED-Chipträger 6 nicht notwendiger plan ausgeführt sein muss. Im Beispiel der FIG 8 weist der LED-Chipträger 6 zwei leicht zueinander geneigte Teilflächen im Sinne einer Kerbe auf, welche jeweils einen LED-Chip 3, 4 aufnehmen. Die beiden Teilflächen sind gleichfalls plan. Im Beispiel der FIG 9 weist der LED-Chipträger 6 gleichfalls zwei Teilflächen auf. Diese weisen im Vergleich zur vorherigen Ausführungsform eine gleiche Orientierung auf. Beide Teilflächen sind durch eine Stufe im Chipträger 6 voneinander getrennt. Die Stufung ist so gewählt, dass bei unterschiedlicher Bauteildicke der beiden LED-Chips 3, 4 ihre optisch aktiven Flächen in einer gemeinsamen Ebene liegen.

FIG 10 zeigt ein Beispiel für einen erfindungsgemässen Streulichtrauchmelder 100 mit einem Meldergehäuse 13 und mit einer Öffnung OF für den möglichen Durchtritt von zu detektierendem Rauch. Das Meldergehäuse 13 setzt sich aus einem Grundkörper 14 und aus einer Melderkappe 15 zusammen. Im Meldergehäuse 13 ist eine gegenüber Umgebungslicht abgeschirmte, jedoch für Rauch durchlässige Detektionseinheit 10 angeordnet. Mit "abgeschirmt" ist hier eine Abschirmung der Detektionseinheit 10 gegenüber direktem Umgebungslicht gemeint. Mit dem Bezugszeichen 16 ist ein Insektenschutz gegen das Eindringen von Insekten bezeichnet. Mit dem Bezugszeichen 18 ist ein Mikrocontroller als Steuereinheit bezeichnet, der auf einer Leiterplatte als Schaltungsträger 17 angeordnet ist. Der Mikrocontroller 18 ist zur Ansteuerung der jeweiligen zweifarbigen Leuchtdioden, zur Erfassung eines Sensorsignals vom jeweiligen Photosensor sowie zur messtechnischen Auswertung der Signale und zur Ausgabe einer Warnmeldung und/oder Alarmmeldung AL eingerichtet, falls ein Mindestkonzentrationswert von Rauch detektierbar ist.

FIG 11 zeigt ein Beispiel für die spezifische spektrale Empfindlichkeit S_{Rel} einer Silizium-PIN-Photodiode 2 mit erhöhter Blauempfindlichkeit. Über der Abszisse ist die Lichtwellenlänge λ des detektierten Lichts in Nanometer aufgetragen, über der Ordinate die spezifische spektrale Empfindlichkeit S_{Rel} am Beispiel einer Silizium-PIN-Photodiode vom Typ BPW34B der Fa. OSRAM in Prozentwerten. Die spektrale Empfindlichkeit S_{Rel} ist mit einem 100 %-Wert auf die spektral empfindlichste Lichtwellenlänge bei 850 nm normiert. Wie das Diagramm zeigt, ist die spektrale "blaue" Empfindlichkeit SEB des Photosensors 2 für blaues Licht mit einem Wellenlängenwert A1 von 470 nm mit 52 % in etwa 1.7 mal schlechter als die spektrale "rote" Empfindlichkeit SER des Photosensors 2 für infrarotes Licht bei einem Wellenlängenwert A2 von 940 nm mit 90 %.

### Bezugszeichenliste

- 1, 1V, 1R: Zweifarben-LED, Leuchtdiode
- 2, 2V, 2R: Photosensor, Photodiode, Silizium-PIN-Photodiode
- 3, 4: LED-Chip, Flächenstrahler
- 5: Reflektor, Reflektorring
- 6: LED-Chipträger, Träger, Trägerplatte
- 7: Kontaktierungsflächen
- 8: Bonddrähte
- 9: Gehäuse, Kunststoffgehäuse
- 10: Detektionseinheit, Messkammer
- 11: Lamelle, Lichtabschirmelement
- 12: Blende, Abschirmung
- 13: Meldergehäuse
- 14: Grundkörper
- 15: Melderkappe
- 16: Insektenschutz, Gitter
- 17: Schaltungsträger, Leiterplatte
- 18: Steuereinheit, Mikrocontroller
- 70-72: Anschlusskontakte
- 100: Rauchmelder, Brandmelder

- CA: Chipachse
- EA: Empfangsachse, optische Hauptachse des Empfängers
- OF: Raucheintrittsöffnung
- QA: Querachse
- SA: Sendeachse, optische Hauptachse der Leuchtdiode
- SEB: ("blaue") spektrale Empfindlichkeit
- SER: ("rote") spektrale Empfindlichkeit
- S_{Rel}: relative spektrale Empfindlichkeit
- SV: Streuzentrum, Streuvolumen, Messvolumen
- W: Winkelebene, gemeinsame Ebene
- αV, αR: Streuwinkel
- λ: Lichtwellenlänge
- Λ1, Λ2: Wellenlängenwerte

## Patentansprüche

1. Streulichtrauchmelder mit einer nach dem Streulichtprinzip arbeitenden Detektionseinheit (10), mit einer ersten und zweiten Leuchtdiode (1V, 1R) zum Bestrahlen von zu detektierenden Partikeln sowie mit einem dafür spektral empfindlichen gemeinsamen Photosensor (2), wobei beide Leuchtdioden (1V, 1R) jeweils eine Sendeachse (SA) und der Photosensor (2) eine Empfangsachse (EA) aufweisen, wobei beide Leuchtdioden (1V, 1R) sowie der Photosensor (2) derart zueinander angeordnet und ausgerichtet sind, dass alle drei Achsen (SA, EA) in einer gemeinsamen Ebene (W) liegen, wobei die erste Leuchtdiode (1V) mit dem Photosensor (2) unter einem Vorwärtsstreuwinkel (αV) und die zweite Leuchtdiode (1R) mit dem Photosensor (2) unter einem Rückwärtsstreuwinkel (αR) angeordnet ist, **dadurch gekennzeichnet, dass** beide Leuchtdioden (1V, 1R) jeweils einen ersten und zweiten LED-Chip (3, 4) zum Aussenden eines jeweiligen ersten und zweiten Lichtbündels (BL, RO) mit Licht in einem ersten und in einem davon verschiedenen zweiten Wellenlängenbereich aufweisen.

2. Streulichtrauchmelder mit einer nach dem Streulichtprinzip arbeitenden Detektionseinheit (10), mit einer Leuchtdiode (1) zum Bestrahlen von zu detektierenden Partikeln sowie mit einem dafür spektral empfindlichen ersten und zweiten Photosensor (2V, 2R), wobei beide Photosensoren (2V, 2R) jeweils eine Empfangsachse (EA) und die Leuchtdiode (1) eine Sendeachse (SA) aufweisen, wobei beide Photosensoren (2V, 2R) sowie die Leuchtdiode (1) derart zueinander angeordnet und ausgerichtet sind, dass alle drei Achsen (EA, SA) in einer gemeinsamen Ebene (W) liegen, wobei der erste Photosensor (2V) mit der Leuchtdiode (1) unter einem Vorwärtsstreuwinkel (αV) und der zweite Photosensor (2R) mit der Leuchtdiode (1) unter einem Rückwärtsstreuwinkel (αR) angeordnet ist, **dadurch gekennzeichnet, dass** die Leuchtdiode (1) einen ersten und zweiten LED-Chip (3, 4) zum Aussenden eines ersten und zweiten Lichtbündels (BL, RO) mit Licht in einem ersten und in einem davon verschiedenen zweiten Wellenlängenbereich aufweist.

3. Streulichtrauchmelder nach Anspruch 1 oder 2, wobei das Verhältnis der optisch aktiven Oberfläche des jeweilige ersten LED-Chips (3) zu der optisch aktiven Oberfläche des jeweiligen zweiten LED-Chips (4) bei der jeweiligen Leuchtdiode (1V, 1R, 1) in einem Bereich von 1.3 bis 12, insbesondere in einem Bereich von 2.5 bis 6.5 liegt.

4. Streulichtrauchmelder nach einem der vorherigen Ansprüche,
- wobei die jeweilige Leuchtdiode (1V, 1R, 1) einen orthogonal zu ihrer Sendeachse (SA) angeordneten LED-Chipträger (6) aufweist,
- wobei die jeweiligen beiden LED-Chips (3, 4) nebeneinander auf dem LED-Chipträger (6) angeordnet sind, und
- wobei die jeweilige Leuchtdiode (1V, 1R, 1) derart um ihre Sendeachse (SA) gedreht zum Photosensor (2, 2V, 2R) ausgerichtet ist, dass eine durch beide LED-Chips (3, 4) verlaufende jeweilige Chipachse (CA) orthogonal und/oder parallel zur gemeinsamen Ebene (W) verläuft.

5. Streulichtrauchmelder nach einem der vorherigen Ansprüche, wobei die jeweiligen beiden LED-Chips (3, 4) derart nebeneinander angeordnet sind, dass ihre jeweilige geometrische Mitte einen gleichen Abstand zur Sendeachse (SA) der jeweiligen Leuchtdiode (1V, 1R, 1) aufweist.

6. Streulichtrauchmelder nach einem der vorherigen Ansprüche, wobei der jeweilige erste LED-Chip (3) zum Aussenden von Licht im Wellenlängenbereich von 350 nm bis 500 nm ausgebildet ist und wobei der jeweilige zweite LED-Chip (4) zum Aussenden von Licht im Wellenlängenbereich von 665 nm bis 1000 nm ausgebildet ist.

7. Streulichtrauchmelder nach Anspruch 6, wobei der jeweilige erste LED-Chip (3) zum Aussenden von Licht mit einer Wellenlänge von 460 nm ± 40 nm oder 390 nm ± 40 nm und der jeweilige zweite LED-Chip (4) zum Aussenden von Licht mit einer Wellenlänge von 940 nm ± 40 nm oder 860 nm ± 40 nm ausgebildet ist.

8. Streulichtrauchmelder nach einem der vorherigen Ansprüche, wobei die jeweilige Leuchtdiode (1V, 1R, 1) ein Gehäuse (9) aus einem insbesondere transparenten Kunststoff aufweist und wobei das Gehäuse (9) in einem Bereich zwischen dem Lichtaustritt aus den jeweiligen beiden LED-Chips (3, 4) und dem Lichtaustritt an der Aussenseite des Gehäuses (9) eine optische Linse (14) ausbildet.

9. Streulichtrauchmelder nach einem der vorherigen Ansprüche, wobei die jeweilige Leuchtdiode (1V, 1R, 1) und/oder der jeweilige Photosensor (2, 2V, 2R) ein SMD-Bauelement oder ein Bauelement für eine Durchlochmontage ist.

10. Streulichtrauchmelder nach einem der vorherigen Ansprüche, wobei der Streulichtrauchmelder eine mit der jeweiligen Leuchtdiode (1V, 1R, 1) und mit dem jeweiligen Photosensor (2, 2V, 2R) verbundene elektronische Steuereinheit aufweist, wobei die Steuereinheit dazu eingerichtet ist, eine Warnmeldung und/oder eine Alarmmeldung auszugeben, falls ein Mindestkonzentrationswert von Rauch detektierbar ist.

11. Streulichtrauchmelder nach einem der vorherigen Ansprüche, wobei der jeweilige Photosensor (2, 2V, 2R) eine Halbleiter-Photodiode, insbesondere eine Silizium-PIN-Photodiode ist.

12. Streulichtrauchmelder nach einem der vorherigen Ansprüche, wobei die jeweiligen beiden LED-Chips (3, 4) durch die elektronische Steuereinheit abwechselnd gepulst ansteuerbar sind.

13. Streulichtrauchmelder nach einem der vorherigen Ansprüche, wobei die jeweiligen beiden Leuchtdioden (1V, 1R) oder die jeweiligen beiden Photosensoren (2V, 2R) typgleiche Bauelemente sind.

14. Streulichtrauchmelder nach einem der vorherigen Ansprüche, wobei der Vorwärtsstreuwinkel (αV) in einem Bereich von 20° bis 90°, insbesondere von 30° bis 70°, und der Rückwärtsstreuwinkel (α) in einem Bereich von mehr als 90° bis 160°, insbesondere von 110° bis 150°, liegt.

15. Streulichtrauchmelder nach einem der vorherigen Ansprüche, wobei der Streulichtrauchmelder ein Meldergehäuse (13) mit zumindest einer Öffnung (OF) für den möglichen Durchtritt von zu detektierendem Rauch sowie die im Meldergehäuse (13) angeordnete, gegenüber Umgebungslicht abgeschirmte Detektionseinheit (10) aufweist.
